# EUROPEAN PATENT SPECIFICATION

(11) **EP 2 509 100 B1**
(45) Date of publication and mention of the grant of the patent: **14.08.2019**
(21) Application number: 11183181.4
(22) Date of filing: 28.09.2011
(51) Int. Cl.: H01J 37/34, C23C 14/00, H01J 37/32

(54) **Integrated anode and activated reactive gas source for use in a magnetron sputtering device**
Integrierte Anode und aktivierte reaktive Gasquelle zur Verwendung in einer Magnetron-Sputtervorrichtung
Anode et source de gaz réactif activé intégrées pour une utilisation dans un dispositif de pulvérisation magnétron

(30) Priority: 06.04.2011 US 472494 P
(43) Date of publication of application: 10.10.2012
(73) Proprietor: Viavi Solutions Inc., San Jose, CA 95002 (US)
(72) Inventor: Ockenfuss, Georg J., Santa Rosa, CA 95404 (US)
(74) Representative: Murgitroyd & Company

(56) References cited:
- EP-A2- 1 628 324
- EP-A2- 2 378 538
- WO-A2-2007/118204
- JP-A- 2000 226 652
- US-A- 4 946 576
- US-A- 5 855 745
- US-A1- 2006 049 041
- MARKUS K. TILSCH MARKUS K. TILSCH ET AL: "Manufacturing of precision optical coatings", CHINESE OPTICS LETTERS, vol. 8, no. S1, 1 January 2010 (2010-01-01), pages 38-43, XP055114258, ISSN: 1671-7694, DOI: 10.3788/COL201008S1.0038
- KAREN D. HENDRIX ET AL: "<title>Demonstration of narrowband notch and multi-notch filters</title>", PROCEEDINGS OF SPIE, vol. 7067, 28 August 2008 (2008-08-28), page 706702, XP055114099, ISSN: 0277-786X, DOI: 10.1117/12.795498

## Description

### FIELD OF THE INVENTION

This invention relates generally to a magnetron sputtering device for depositing materials onto substrates. More particularly the invention relates to an integrated anode and activated reactive gas source for use in a magnetron sputtering device, a magnetron sputtering device incorporating the same and a method of using the same.

### BACKGROUND OF THE INVENTION

Sputter coating is a widely used technique for depositing a thin film of material on a substrate. In a sputtering deposition process ions are usually created by collisions between gas atoms and electrons in a glow discharge. The ions are accelerated into the target of coating material at the cathode by an electric field causing atoms of the target material to be ejected from the target surface. A substrate is placed in a suitable location so that it intercepts a portion of the ejected atoms. Thus, a coating of target material is deposited on the surface of the substrate. In reactive sputtering a gaseous species is also present at the substrate surface and reacts with, and in some embodiments combines with, the atoms from the target surface to form the desired coating material.

In operation, when the sputter gas, e.g. argon, is admitted into a coating chamber, a DC voltage applied between the cathode and the anode ionizes the argon into a plasma, and the positively charged argon ions are attracted to the negatively charged cathode. The ions strike the target in front of the cathode with a substantial energy and cause target atoms or atomic clusters to be sputtered from the target. Some of the target particles strike and deposit on the wafer or substrate material to be coated, thereby forming a film.

To attain increased deposition rates and lower operating pressures, magnetically enhanced cathodes are used. In a planar magnetron, the cathode includes an array of permanent magnets arranged in a closed loop and mounted in a fixed position in relation to the flat target plate of coating material. Thus, the magnetic field causes the electrons to travel in a closed loop, commonly referred to as a "race track", which establishes the path or region along which sputtering or erosion of the target material takes place. In a magnetron cathode, a magnetic field confines the glow discharge plasma and increases the path length of the electrons moving under the influence of the electric field. This results in an increase in the gas atom-electron collision probability, thereby leading to a much higher sputtering rate than that obtained without the use of magnetic confinement. Furthermore, the sputtering process can be accomplished at a much lower gas pressure.

Typically a magnetron sputtering system is operated at a pressure of 2^{∗}10⁻² Pa-1^{∗}10⁻¹ Pa during sputtering. To establish this pressure, typically the chamber is pumped down to a pressure of <1^{∗}10⁻⁴ Pa and a controlled flow of a gas, typically Argon (and in case of reactive sputtering Argon and Oxygen or Nitrogen) is fed into the chamber to maintain the desired pressure. In the case of a diode system, i.e. when no magnets are used, a pressure of >2 Pa is required to be able to ignite and sustain a plasma. High pressure has the disadvantage that the mean-free path is greatly reduced, which causes extensive gas scatter. This results in hazy coatings.

In the magnetron sputtering device the anode provides a charge differential to the negatively charged cathode. This can be provided as simply as an electric charge provided to the chamber walls. However, the sputtered material is also deposited on any surface exposed to the sputtered atoms. If the coating is an electrically insulating material, such as a metal oxide, the build up of the material on other parts of the sputtering apparatus can cause problems. In particular, the build up of an insulating coating on the anode interferes with the ability of the anode to remove electrons from the plasma, as required to maintain the plasma's charge balance. This destabilizes the plasma and interferes with deposition control. Coating build-up will cause the anode location to move to another surface in the system. This instability affects coating quality. Numerous prior art anodes have been proposed to overcome the problems of the anode becoming coated with the coating material. Many prior art anodes function at very high voltages that also increase the problems of arcing, which damages coating quality. A low voltage anode that can provide a stable anode location is desired for ensuring consistent coating quality.

An anode vessel is disclosed in US Publication No. 20060049041 filed March 7, 2005 that can provide a stable anode location at low voltage. The anode comprises an interior surface of a vessel having a single opening in communication with the coating chamber. The interior surface of the vessel is the preferred return path for electrons. The anode vessel is also the source of sputter gas, which passes from an inlet port in the anode vessel through the single opening into the coating chamber. The size of the single opening and its location prevent coating material from building up on the charged interior surface of the anode. A similar anode vessel is disclosed in EP 1 628 324 A2, published February 22, 2006, in the article "Manufacturing of precision optical coatings" by Tilsch et al., Chinese Optics Letters, 2010, Vol. 8, Supplement, pp. 38 to 43, and in the article "Demonstration of narrowband notch and multi-notch filters" by Hendrix et al., Proceedings of SPIE, 2008, Vol. 7067, pp. 706702-1 to 706702-14. Document JP2000226652 discloses a method for producing a thin film, wherein reactive and carrier gases are introduced in a silica tube, which is provided at approximately the center part or in the vicinity of the target, and are inductively excited and activated therein. Document US4946576 discloses a cathode sputtering process, whereby thin films may be deposited onto a substrate, using a reactive gas mixture that is activated by a gas discharge in front of the substrate. Document US5855745 discloses a reactive magnetron sputtering apparatus wherein a reactant gas is discharged into an anode/ion source assembly and activated therein.

Many optical coatings require the deposition of oxides or other compounds. Such materials are preferably produced in reactive sputter mode where a metallic target is sputtered and oxygen, nitrogen, or another reactive gas is added to the process. The sputtered material and the activated oxygen species arrive simultaneously at the substrate. The optimum flow, of oxygen for example, for the optimum oxygen partial pressure needs to be found. If the oxygen flow is too low, the films are not stoichiometric and have high absorption losses. If it is too high, the target surface becomes more oxidized than necessary preventing operation at the highest possible deposition rate. The sputter rate for a metallic target can be ten times higher than that of a fully oxidized target. The oxidation effectiveness can be increased if the oxygen is activated and directed at the substrates, thus increasing the possible deposition rate. The reactive sputter process is disclosed for oxides. All aspects can similarly be applied to nitrides or other reactive processes.

In order to produce dielectric coatings in a magnetron sputtering device with low or no optical absorption profile, it is necessary to provide an additional activated reactive gas source to provide Oxygen or Nitrogen to create a plasma. Examples of commercially available activated reactive gas sources include a PAS from JDSU, a Taurion source from ProVac, a KRI source from Kaufman & Robinson, an APS source from Leybold. Current activated reactive gas sources are complicated. Some require expensive electronics. Some require filaments that have limited lifetime. These devices are very expensive and can be maintenance intensive.

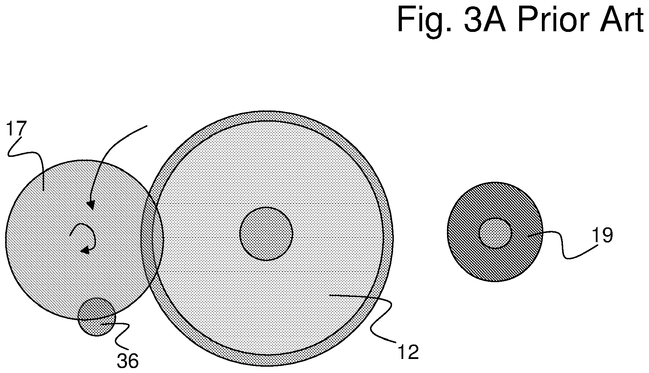

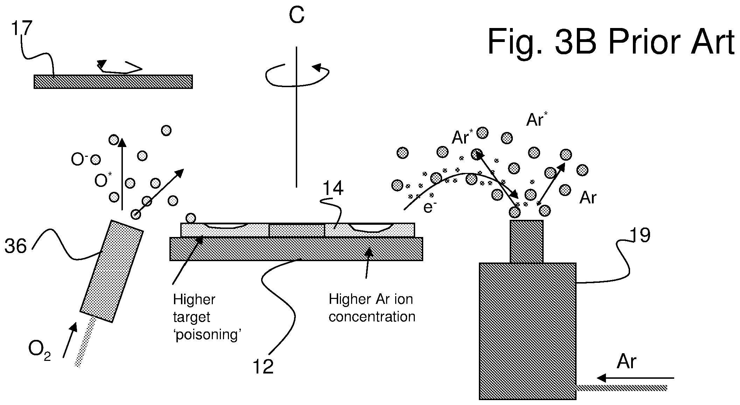

A Prior Art configuration of the anode vessel 19 and a separate reactive gas source 36 is illustrated in Figure 3A and 3B. The cathode 12 is positioned with its center at the central rotational axis C. An anode vessel 19 providing an ionized source of Argon gas is disposed on one side of the cathode 12 and the reactive gas source 36 of ionized Oxygen is disposed on an opposite side of the cathode 12. A substrate 17 rotates about the circumference of the cathode 12 over the reactive gas source 36. In the case of reactive sputtering with a standard cathode 12, a large variation of target wear has been observed which limits the target utilization. The target 14 can be seen in the cross section in Figure 3B, on the side close to the reactive gas (oxidation) source 36, the target wear is low, due to an increase of target oxidation (poisoning); whereas on the side that is close to the anode 19, the target wear is high, due to an increase in plasma density.

A simpler, less expensive and more reliable source for activated reactive gas in a magnetron sputtering device is highly desirable.

It is also desired to increase the efficiency of oxidation of the deposited film in order to increase the deposition rate for reactive sputtering.

It is also desired to maintain a low temperature process despite increased power input in order to be able to process temperature sensitive materials.

### SUMMARY OF THE INVENTION

The present invention has found that by integrating an anode vessel with a source for reactive gas, an activated reactive species can be provided in a magnetron sputtering device for applying dielectric coatings in a simpler, more efficient and cost effective device.

Accordingly, the present invention comprises an integrated anode and activated reactive gas source (20) for use in a magnetron sputtering device (10), as defined in claim 1.

The present invention has a voltage provided to the anode comprising the interior conductive surface of the vessel of 15 to 80 V.

The present invention includes the sputtering gas and reactive gas provided through a single inlet port into the vessel.

The present invention includes the sputtering gas and reactive gas provided through separate inlet ports into the vessel.

The present invention further comprises a magnetron sputtering device for coating objects including the integrated anode and activated reactive gas source in accordance with the present invention, as defined in claim 7.

The magnetron sputtering device in accordance with the present invention wherein a distance from a surface plane of the objects to be coated to a plane containing the single opening of the vessel is equal to or greater than a distance from the surface plane of the objects to be coated to a surface plane of the target.

The magnetron sputtering device in accordance with the present invention, wherein two or more vessels comprising integrated anode and activated reactive gas sources are disposed at substantially opposite positions adjacent the cathode.

The magnetron sputtering device in accordance with the present invention, including a further reactive gas source to augment the integrated anode and activated reactive gas source.

The magnetron sputtering device in accordance with the present invention, wherein the two integrated anode and activated reactive gas sources operate continuously in operation.

The magnetron sputtering device in accordance with the present invention, wherein the two integrated anode and activated reactive gas sources operate intermittently, alternating between them at a frequency of 1 Hz or greater.

The present invention further comprises a method of using the integrated anode and activated reactive gas source in accordance with the present invention, as defined in claim 16.

### BRIEF DESCRIPTION OF THE DRAWINGS

Exemplary embodiments of the invention will now be described in accordance with the drawings, in which:
Figure 1 is an isometric view of the coating system of the present invention with some outer wall removed;
Figure 2 is a cross-section of an anode vessel for use in the magnetron sputtering device;
Figure 3A is a schematic top view of a Prior Art separate anode vessel and activated reactive gas source;
Figure 3B is a schematic cross-section of the Prior Art separate anode vessel and activated reactive gas source;
Figure 4A is a schematic top view of a coating geometry in accordance with the present invention including an integrated anode and activated reactive gas source;
Figure 4B is a schematic cross-section of the coating geometry of Figure 4A;
Figure 5A is a schematic top view of an alternative coating geometry in accordance with the present invention, in which the substrates to be coated pass over the cathode;
Figure 5B is a schematic cross-section of the coating geometry of Figure 5A;
Figure 6A is a schematic top view of a coating geometry in accordance with the present invention in which the integrated anode and activated reactive gas source is disposed at the center of a ring shaped cathode;
Figure 6B is a schematic cross-section of the coating geometry of Figure 6A;
Figure 7A is a schematic top view of a coating geometry in accordance with the present invention in which two integrated anode and activated reactive gas sources are incorporated; and,
Figure 7B is a schematic cross-section of the coating geometry of Figure 7A.

### DETAILED DESCRIPTION

We observed that the anode vessel disclosed in US Publication No. 20060049041 filed March 7, 2005 in its typical arrangement contains a plasma. The plasma is ignited by the high density of electrons coming from the cathode 12 and returning to the power supply through the anode 20. The effect of ion creation and the creation of activated species is similar to the reactions occurring at the cathode: energetic e- + Ar =≥ 2e- + Ar+ or energetic e- + Ar => e- + Ar*. There would not be visible plasma at the anode without this activation of the argon atoms. We decided to test adding oxygen to the anode to test if it would generate activated and ionized oxygen. By coupling the oxygen feed into the anode vessel 20, we were able to deposit a clear SiO₂ single layer. This is a clear indication that the anode operating with argon and oxygen is behaving as an anode and an activated reactive gas source. Additionally, we did not observe oxidation of the inside walls of the anode.

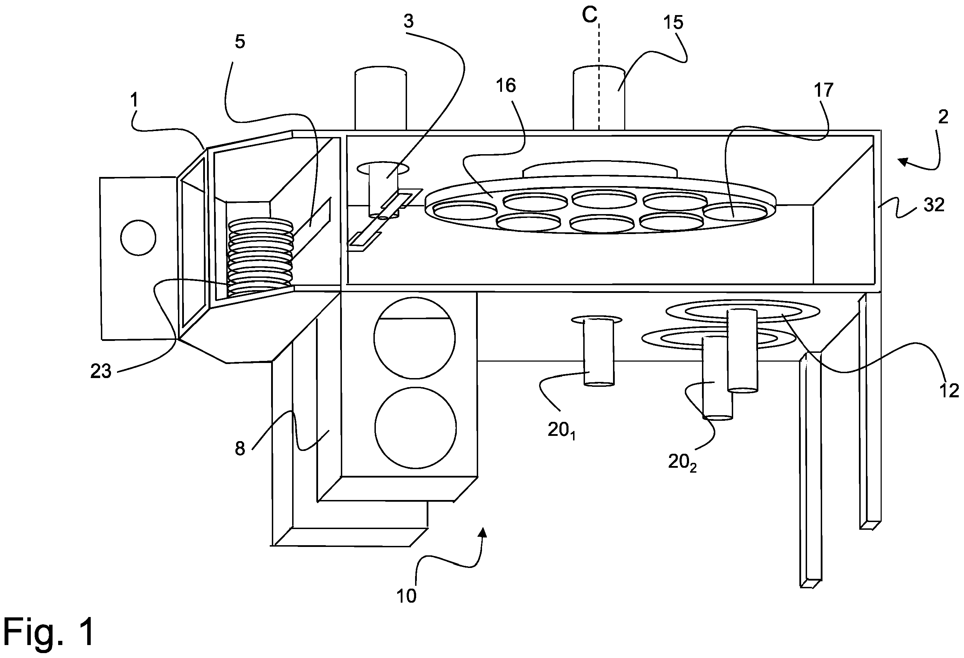

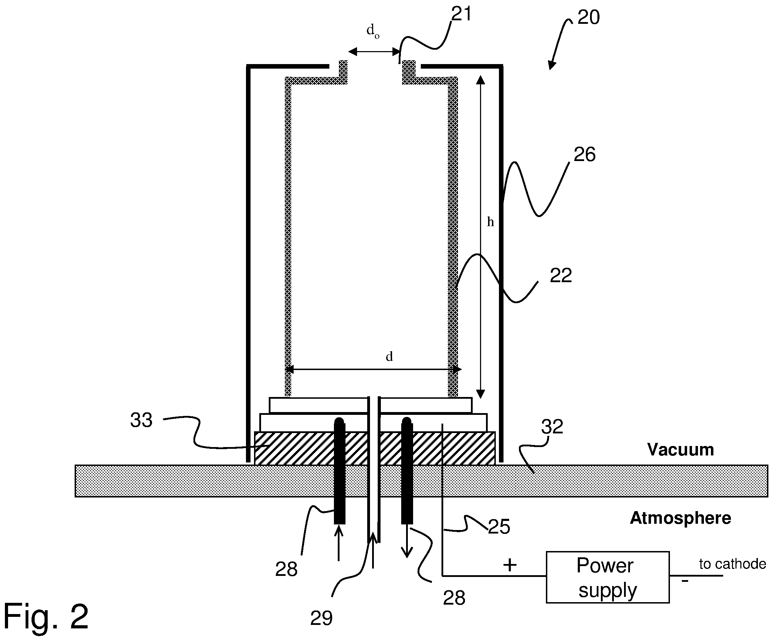

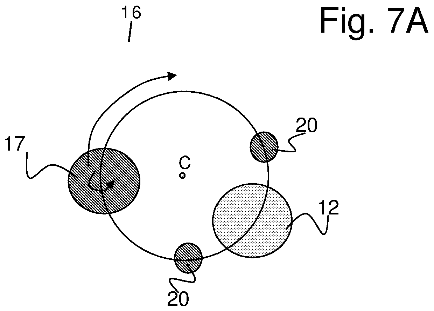

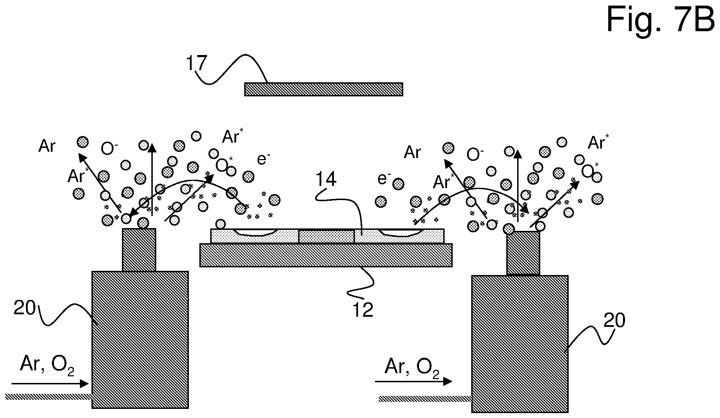

An isometric view of the coating chamber 2 of a magnetron sputter coating device 10 is shown in Fig. 1. Pumps 8 evacuate the coating chamber 2 for operation under vacuum conditions, understood to mean where the pressure is below atmospheric pressure. The chamber walls 32 are grounded and isolated from the positively charged anode 20 and the negatively charged cathode 12. A planetary drive 15 comprises a carrier 16 or rack rotatable about a central rotational axis C, with a plurality of eg. seven or eight, planets 17 supported radially about the central rotational axis C. A ring shaped cathode 12, in this embodiment two cathodes 12, are shown. Vessel 20 comprises an integrated anode and activated reactive gas source with an opening in communication with the coating chamber 2. Reference numerals 20₁ and 20₂ distinguish different positions of the integrated anode and activated reactive gas source 20. An additional integrated anode and activated reactive gas source 20₂ is shown at the center of cathode 12. These positions can be alternative positions, depending on whether a ring cathode or a solid cathode is used, or both can be used as shown. Even in the absence of a ring cathode, two integrated anode and activated reactive gas sources 20 can be positioned on opposite sides of a cathode, as shown in Figures 7A and B, to enable a higher deposition rate. The integrated anode and activated reactive gas source 20 (see Figure 2) includes one or more inlet ports 29 to supply sputter gas and reactive gas to the coating chamber 2. The magnetron sputter coating device 10 includes a load lock 1 for loading and unloading substrates or other objects 23, for coating. This allows the deposition chamber 2 to remain under vacuum conditions at all times.

The integrated anode and activated reactive source can be implemented in a pulsed DC magnetron sputtering, DC magnetron, AC magnetron sputtering and rf magnetron sputtering.

The integrated anode and activated reactive gas source 20 provides a charge differential to the negatively charged cathode. Referring now to Figure 2 an integrated anode and activated reactive gas source 20 is shown in the form of a container or vessel having inner conductive surface of copper or stainless steel 22 comprising the anode and having a single opening 21 at a first end for communicating with a vacuum chamber 2 to which it is directly coupled. The opening 21 can be located on a side or end of the vessel. Conveniently, the opening 21 can be positioned in the chamber walls 32 with the vessel itself outside the chamber 2. This achieves space efficiency in the chamber and assists service access. The opening 21 is positioned adjacent the cathode 12 approximately positioning the plume of sputtered material from the target and the plume of activated and ionized oxygen to overlap as closely as possible to simultaneously arrive at the substrate to be coated. The outer surface 26 of the vessel 20 is electrically insulated. In the cross sectional view water cooling pipes 28 are shown substantially around the anode 20 for maintaining the temperature of the anode in operation. A gas inlet port 29 is shown for providing a conduit into which sputter gas and reactive gas, Oxygen or Nitrogen, may enter the vessel 20. The gasses are mixed prior to the inlet port 29, or alternately two separate inlet ports 29 can be coupled into the vessel 20. The flow of reactive gas can be shut off when the coating device 10 is not creating dielectric coatings, so that only sputter gas flows through the vessel 20. The size of the opening 21 is relatively small and the flow of gases can be selected to locally pressurize the vessel 20. The relatively small opening 21, having a circumference significantly smaller than the circumference of the vessel, and the location of the opening 21 out of a line of sight to the target prevent coating material from entering and coating the inner conductive surface 22 of the anode. In operation the vessel 20 is pressurized above the chamber pressure with the flow of argon gas and a reactive gas that together promote the formation of plasma in the coating chamber 2. A plasma is ignited by the high density of electrons coming from the cathode and returning to the power supply through the anode, and is sustained by a maintenance voltage thereafter. The argon plasma has proven to be sufficient to ignite the reactive gas simultaneously. Pressure within the vessel 20, higher than the rest of the vacuum coating chamber 2, allows for a lower anode voltage that promotes a more stable sputtering condition. Positive power supply lead 25 connects the power supply to the inner conductive surface 22 of the anode. The integrated anode and activated reactive gas source device 20 shown in Figure 2 was designed to function with a low anode voltage and little or no arcing. A low anode voltage of approximately +15 to +80 V is preferred to reduce process variation. The anode inner conductive surface 22 is electrically insulated from the grounded chamber walls 32 by an insulating material 33.

In a preferred embodiment the integrated anode and activated reactive gas source comprises a vessel of cylindrical shape with a diameter of at least d = 10 cm and a length of at least h = 20 cm with an opening (21) to the vacuum chamber (2) at one end as shown in Figure 2 and closed at the opposite end. For low scattering processes the chamber pressure is below 0.267 Pa (2 mTorr).

A higher pressure at the anode is achieved by the smaller opening 21 of the anode 20 and a controlled flow of process gas and reactive gas into the vessel 20 via the inlet port 29. An optimum opening has an area of about 20 cm² and is preferably round. In operation the vessel 20 can be pressurized to more than 0.400 Pa (3 mTorr).

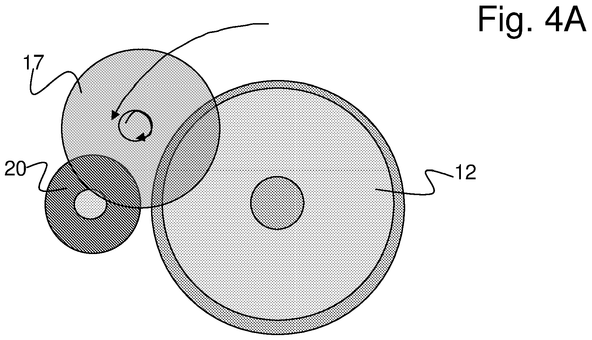

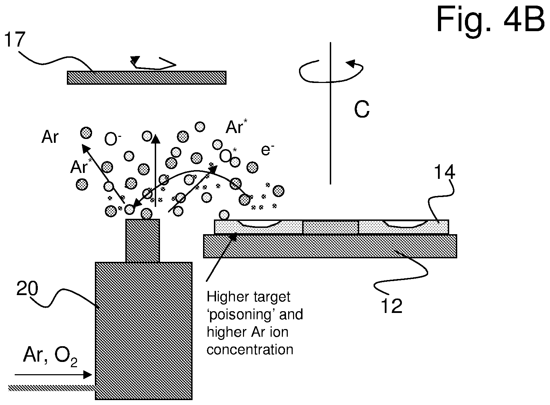

In one configuration of a magnetron sputtering device incorporating an integrated anode and activated reactive gas source, shown in Figures 4A and 4B, a cathode 12 is disposed with its center at the central axis C. The integrated anode and activated reactive gas source 20 is located adjacent the cathode 12. At least one substrate 17 mounted to a coating area is rotated about an orbit of the central axis C at a radial distance substantially equal to the distance of the integrated anode and activated reactive gas source 20 from the central axis C, so that the at least one substrate 17 passes over the opening 21 of the integrated anode and activated reactive gas source. One would expect a lower gradient of target wear in this configuration than in Figure 3A,B, because higher plasma density (high Ar ion concentration) and poisoning of the target are at the same location.

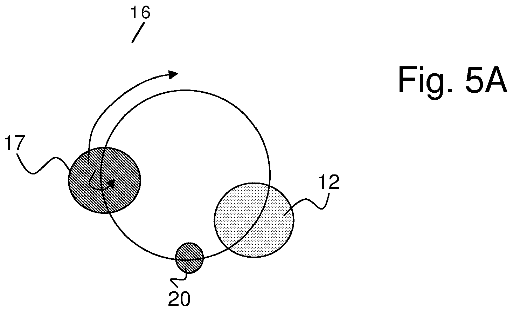

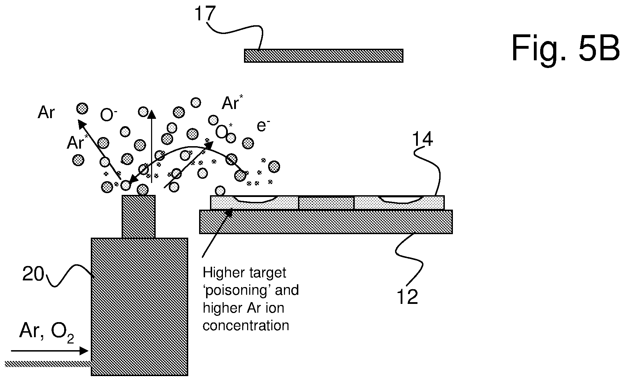

In another configuration of a magnetron sputtering device incorporating an integrated anode and activated reactive gas source, shown in Figures 5A and 5B the cathode 12 is translated a radial distance from the central axis C. One or more substrates 17 are rotated in an orbit having a radius equal to the radial distance the cathode 12 is translated. The integrated anode and activated reactive gas source 20 is also located a same radial distance from the center adjacent the cathode 12, so that the one or more substrates 17 pass over the cathode 12 and integrated anode and activated reactive gas source 20 in quick succession.

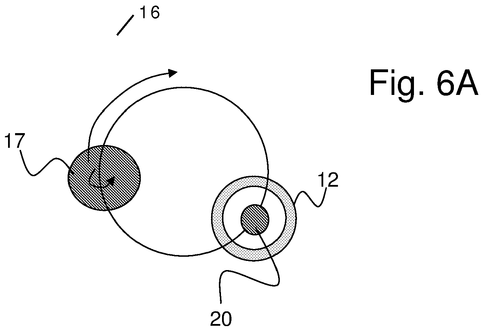

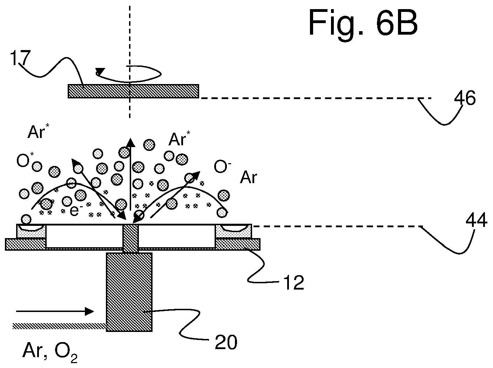

An integrated anode and activated reactive gas source 20 can be located with its opening 21 at the center of the ring cathode in a magnetron sputtering device, as shown in Figure 1 and Figure 6, since the opening 21 is relatively far away from strong magnetic fields. This improves the symmetry of the system, which is expected to cause a uniform wear pattern of the target, which improves target utilization.

In a preferred embodiment shown in Figures 6A and 6B, by including the oxygen source in the anode vessel together as an integrated anode and activated reactive gas source 20 in the center of the cathode 12, a very symmetric system is created and target wear is expected to be uniform. An auxiliary activated reactive source located a distance from the cathode 12 (eg. at 20₁ as shown in Fig. 1) can be provided in addition to enable a higher deposition rate. Experiments have shown that higher deposition rates of metal oxides with low absorption can be achieved when the plume of sputtered material from the target and the plume of activated and ionized oxygen overlap and simultaneously arrive at the substrate to be coated. Thus, having the integrated anode and activated reactive gas source 20 in the center of the target is an almost ideal solution. The source output can be ionized, or otherwise activated oxygen species (e.g. atomic oxygen, ozone). The opening 21 of the integrated anode and activated reactive gas source 20 is positioned just at a target surface plane 44 in the center of the cathode 12. Substrates 17 are supported for rotation over the concentric cathode 12 and integrated anode and activated reactive gas source 20. A distance from a surface plane 46 of the objects to be coated to a plane containing the single opening 21 of the vessel 20 is equal to or greater than a distance from the surface plane of the objects to be coated to a surface plane of the target.

A further example configuration of a magnetron sputtering device incorporating and integrated anode and activated reactive gas source is shown in Figures 7A and 7B in which two integrated anode and activated reactive gas source vessels 20 are disposed on opposite sides of a cathode 12, each vessel 20 and the cathode located a same radial distance from a central rotation axis C. A support for one or more substrates to be coated, is adapted to support the substrates in a rotation about the central rotation axis C the same radial distance so as to pass the substrates above the cathode and integrated anode and activated reactive gas sources. The two integrated anode and activated reactive gas sources 20 can be used both continuously, or cycled alternately between them at a frequency of 1 Hz or greater.

Numerous other configurations for use in different magnetron platforms, such as in-line or with rectangular or cylindrical cathodes are also feasible .The invention is defined by the claims.

## Claims

1. An integrated anode and activated reactive gas source (20) for use in a magnetron sputtering device (10), the integrated anode and reactive gas source (20) comprising:
a vessel including:
a conductive interior surface (22), adapted to be electrically coupled, in operation, to a positive output of a power supply, such that it serves, in operation, as an anode providing a voltage difference to a cathode (12) and as a primary return path for electrons;
a single opening (21) arranged to communicate, in operation, with a coating chamber (2) of the magnetron sputtering device (10);
an insulated outer surface (26) arranged to electrically isolate, in operation, the vessel from chamber walls (32) of the coating chamber (2); and
one or more gas inlet ports (29);
a source of sputtering gas and a source of reactive gas; wherein one of the one or more gas inlet ports (29) is arranged, in operation, to provide a sputtering gas from the source of sputtering gas into the vessel, and the integrated anode and activated reactive gas source is arranged such that, in operation, the sputtering gas is provided through the single opening (21) of the vessel into the coating chamber (2); and wherein one of the one or more gas inlet ports (29) is arranged, in operation, to provide a reactive gas from the source of reactive gas into the vessel, and the integrated anode and activated reactive gas source is arranged, in operation, to activate the reactive gas within the vessel and is arranged such that, in operation, the activated reactive gas is provided through the single opening (21) of the vessel into the coating chamber (2).

2. The integrated anode and activated reactive gas source (20) defined in claim 1, wherein a circumference of the single opening (21) of the vessel is smaller than a circumference of the vessel to shield in operation the conductive interior surface (22) from most sputtered material.

3. The integrated anode and activated reactive gas source (20) defined in claim 2, wherein the single opening (21) of the vessel is dimensioned such that, in operation, a flow of sputtering gas and reactive gas can be selected to raise the pressure locally within the vessel above the pressure in the coating chamber (2).

4. The integrated anode and activated reactive gas source (20) defined in claim 3, wherein the power supply is arranged to provide, in operation, a voltage of 15 to 80 V is to the conductive interior surface (22).

5. The integrated anode and activated reactive gas source (20) defined in claim 4, wherein the one or more gas inlet ports (29) consist of a single gas inlet port (29), and wherein the single gas inlet port (29) is arranged to provide, in operation, the sputtering gas and the reactive gas into the vessel.

6. The integrated anode and activated reactive gas source (20) defined in claim 4, wherein the one or more gas inlet ports (29) consist of separate gas inlet ports, and wherein the separate gas inlet ports are arranged to provide, in operation, the sputtering gas and the reactive gas into the vessel.

7. A magnetron sputtering device (10) for coating objects, the magnetron sputtering device (10) comprising the integrated anode and activated reactive gas source (20) defined in claim 4, and further comprising:
a coating chamber (2) adapted to be evacuated in operation;
a cathode (12) including a target (14) comprising material for forming a coating; and
one or more coating areas (17) arranged to support objects to be coated in the coating chamber (2).

8. The magnetron sputtering device (10) defined in claim 7, wherein a distance from a surface plane (46) of the objects to be coated to a plane containing the single opening (21) of the vessel is equal to or greater than a distance from the surface plane (46) of the objects to be coated to a surface plane (44) of the target (14).

9. The magnetron sputtering device (10) defined in claim 8, further comprising a second integrated anode and activated reactive gas source (20) as defined in claim 4, wherein the two integrated anode and activated reactive gas sources (20) are disposed at substantially opposite positions adjacent to the cathode (12).

10. The magnetron sputtering device (10) defined in claim 8, further comprising an additional activated reactive gas source (36).

11. The magnetron sputtering device (10) defined in claim 8, wherein the one or more coating areas (17) are adapted to rotate about a central rotational axis coincident with a center point of the cathode (12), and wherein the one or more coating areas (17) and the integrated anode and activated reactive gas source (20) are disposed at a same radial distance from the central rotational axis, such that in operation the one or more coating areas (17) pass directly above the single opening (21) of the vessel.

12. The magnetron sputtering device (10) defined in claim 8, wherein the cathode (12) and the integrated anode and activated reactive gas source (20) are disposed adjacent to each other at a same radial distance from a central rotational axis, and wherein the one or more coating areas (17) are adapted to rotate about the central rotational axis at the same radial distance from the central rotational axis as the cathode (12) and the integrated anode and activated reactive gas source (20), such that in operation the one or more coating areas (17) pass directly over the cathode (12) and the integrated anode and activated reactive gas source (20).

13. The magnetron sputtering device (10) defined in claim 9, wherein the cathode (12) is disposed at a radial distance from a central rotational axis, and the two integrated anode and activated reactive gas sources (20) are disposed at the same radial distance from the central rotational axis as the cathode on either side of the cathode (12), wherein the one or more coating areas (17) are adapted to rotate about the central rotational axis at the same radial distance from the central rotational axis as the cathode (12) and the two integrated anode and activated reactive gas sources (20), such that in operation the one or more coating areas (17) pass directly over the cathode (12) and the two integrated anode and activated reactive gas sources (20).

14. The magnetron sputtering device (10) defined in claim 13, wherein in operation the two integrated anode and activated reactive gas sources (20) operate continuously.

15. The magnetron sputtering device (10) defined in claim 13, wherein in operation the two integrated anode and activated reactive gas sources (20) operate in alternation at a frequency of 1 Hz or greater.

16. A method of using the integrated anode and activated reactive gas source (20) defined in claim 1 to provide an activated reactive gas into a coating chamber of a magnetron sputtering device (10), the method comprising:
electrically coupling the conductive interior surface of the vessel to a positive output of a power supply, such that the conductive interior surface serves, in operation, as an anode providing a voltage difference to a cathode and as a primary return path for electrons;
providing a sputtering gas from the source of sputtering gas through one of the one or more gas inlet ports (29) into the vessel, and providing the sputtering gas through the single opening (21) of the vessel into the coating chamber (2); and
providing a reactive gas from the source of reactive gas through one of the one or more gas inlet ports (29) into the vessel, activating the reactive gas within the vessel and providing the activated reactive gas through the single opening (21) of the vessel into the coating chamber (2).

## Patentansprüche

1. Eine integrierte Quelle für eine Anode und aktiviertes Reaktivgas (20) zur Verwendung in einer Magnetron-Sputtervorrichtung (10), wobei die integrierte Quelle für eine Anode und Reaktivgas (20) Folgendes beinhaltet:
ein Gefäß, das Folgendes umfasst:
eine leitende Innenfläche (22), die angepasst ist, um im Betrieb mit einem positiven Ausgang einer Energieversorgung elektrisch gekoppelt zu werden, sodass sie im Betrieb als Anode, die einer Kathode (12) eine Spannungsdifferenz bereitstellt, und als primärer Rückweg für Elektronen dient;
eine einzelne Öffnung (21), die so angeordnet ist, dass sie im Betrieb mit einer Beschichtungskammer (2) der Magnetron-Sputtervorrichtung (10) in Kommunikation ist;
eine isolierte Außenfläche (26), die so angeordnet ist, dass sie das Gefäß im Betrieb von den Kammerwänden (32) der Beschichtungskammer (2) elektrisch isoliert; und
einen oder mehrere Gaseinlassstutzen (29);
eine Quelle für Sputtergas und eine Quelle für Reaktivgas;
wobei einer der einen oder mehreren Gaseinlassstutzen (29) so angeordnet ist, dass er im Betrieb ein Sputtergas von der Sputtergasquelle in das Gefäß bereitstellt, und die integrierte Quelle für eine Anode und aktiviertes Reaktivgas so angeordnet ist, dass im Betrieb das Sputtergas durch die einzelne Öffnung (21) des Gefäßes in die Beschichtungskammer (2) bereitgestellt wird; und
wobei einer der einen oder mehreren Gaseinlassstutzen (29) so angeordnet ist, dass er im Betrieb ein Reaktivgas von der Reaktivgasquelle in das Gefäß bereitstellt, und die integrierte Quelle für eine Anode und aktiviertes Reaktivgas so angeordnet ist, dass sie im Betrieb das Reaktivgas innerhalb des Gefäßes aktiviert und so angeordnet ist, dass im Betrieb das aktivierte Reaktivgas durch die einzelne Öffnung (21) des Gefäßes in die Beschichtungskammer (2) bereitgestellt wird.

2. Integrierte Quelle für eine Anode und aktiviertes Reaktivgas (20) gemäß Anspruch 1, wobei ein Umfang der einzelnen Öffnung (21) des Gefäßes kleiner als ein Umfang des Gefäßes ist, um im Betrieb die leitende Innenfläche (22) gegen das meiste des gesputterten Materials abzuschirmen.

3. Integrierte Quelle für eine Anode und aktiviertes Reaktivgas (20) gemäß Anspruch 2, wobei die einzelne Öffnung (21) des Gefäßes so bemessen ist, dass im Betrieb ein Fluss von Sputtergas und Reaktivgas ausgewählt werden kann, um den Druck lokal innerhalb des Gefäßes über den Druck in der Beschichtungskammer (2) anzuheben.

4. Integrierte Quelle für eine Anode und aktiviertes Reaktivgas (20) gemäß Anspruch 3, wobei die Energieversorgung angeordnet ist, um im Betrieb der leitenden Innenfläche (22) eine Spannung von 15 bis 80 V bereitzustellen.

5. Integrierte Quelle für eine Anode und aktiviertes Reaktivgas (20) gemäß Anspruch 4, wobei der eine oder die mehreren Gaseinlassstutzen (29) aus einem einzelnen Gaseinlassstutzen (29) bestehen und wobei der einzelne Gaseinlassstutzen (29) angeordnet ist, um im Betrieb das Sputtergas und das Reaktivgas in das Gefäß bereitzustellen.

6. Integrierte Quelle für eine Anode und aktiviertes Reaktivgas (20) gemäß Anspruch 4, wobei der eine oder die mehreren Gaseinlassstutzen (29) aus getrennten Gaseinlassstutzen bestehen und wobei die getrennten Gaseinlassstutzen angeordnet sind, um im Betrieb das Sputtergas und das Reaktivgas in das Gefäß bereitzustellen.

7. Eine Magnetron-Sputtervorrichtung (10) zum Beschichten von Objekten, wobei die Magnetron-Sputtervorrichtung (10) die integrierte Quelle für eine Anode und aktiviertes Reaktivgas (20) gemäß Anspruch 4 beinhaltet, und ferner Folgendes beinhaltet:
eine Beschichtungskammer (2), die angepasst ist, um im Betrieb evakuiert zu werden;
eine Kathode (12), umfassend ein Target (14), das Material zum Bilden einer Beschichtung beinhaltet; und
einen oder mehrere Beschichtungsbereiche (17), die so angeordnet sind, dass sie zu beschichtende Objekte in der Beschichtungskammer (2) stützen.

8. Magnetron-Sputtervorrichtung (10) gemäß Anspruch 7, wobei ein Abstand von einer Oberflächenebene (46) der zu beschichtenden Objekte zu einer Ebene, die die einzelne Öffnung (21) des Gefäßes enthält, gleich oder größer als ist als ein Abstand von der Oberflächenebene (46) der zu beschichtenden Objekte zu einer Oberflächenebene (44) des Targets (14).

9. Magnetron-Sputtervorrichtung (10) gemäß Anspruch 8, ferner beinhaltend eine zweite integrierte Quelle für eine Anode und aktiviertes Reaktivgas (20) gemäß Anspruch 4, wobei die zwei integrierten Quellen für eine Anode und aktiviertes Reaktivgas (20) an im Wesentlichen entgegengesetzten Positionen neben der Kathode (12) befindlich sind.

10. Magnetron-Sputtervorrichtung (10) gemäß Anspruch 8, ferner beinhaltend eine zusätzliche Quelle aktivierten Reaktivgases (36).

11. Magnetron-Sputtervorrichtung (10) gemäß Anspruch 8, wobei der eine oder die mehreren Beschichtungsbereiche (17) angepasst sind, um sich um eine mittige Drehachse zu drehen, die mit einem Mittelpunkt der Kathode (12) zusammenfällt, und wobei der eine oder die mehreren Beschichtungsbereiche (17) und die integrierte Quelle für eine Anode und aktiviertes Reaktivgas (20) in einem gleichen radialen Abstand von der mittigen Drehachse befindlich sind, sodass im Betrieb der eine oder die mehreren Beschichtungsbereiche (17) direkt oberhalb der einzelnen Öffnung (21) des Gefäßes passieren.

12. Magnetron-Sputtervorrichtung (10) gemäß Anspruch 8, wobei die Kathode (12) und die integrierte Quelle für eine Anode und aktiviertes Reaktivgas (20) in gleichem radialen Abstand von einer mittigen Drehachse nebeneinander befindlich sind, und wobei der eine oder die mehreren Beschichtungsbereiche (17) angepasst sind, um sich um die mittige Drehachse in demselben radialen Abstand von der mittigen Drehachse wie die Kathode (12) und die integrierte Quelle für eine Anode und aktiviertes Reaktivgas (20) zu drehen, sodass im Betrieb der eine oder die mehreren Beschichtungsbereiche (17) direkt über der Kathode (12) und der integrierten Quelle für Anode und aktiviertes Reaktivgas (20) verlaufen.

13. Magnetron-Sputtervorrichtung (10) gemäß Anspruch 9, wobei die Kathode (12) in einem radialen Abstand von einer mittigen Drehachse befindlich ist und die zwei integrierten Quellen für eine Anode und aktiviertes Reaktivgas (20) in dem gleichen radialen Abstand von der mittigen Drehachse wie die Kathode auf beiden Seiten der Kathode (12) befindlich sind, wobei der eine oder die mehreren Beschichtungsbereiche (17) angepasst sind, um sich um die mittige Drehachse im gleichen radialen Abstand von der mittigen Drehachse zu drehen wie die Kathode (12) und die zwei integrierten Quellen für eine Anode und aktiviertes Reaktivgas (20), sodass im Betrieb der eine oder die mehreren Beschichtungsbereiche (17) direkt über der Kathode (12) und den zwei integrierten Anode und Quellen aktivierten Reaktivgases (20) verlaufen.

14. Magnetron-Sputtervorrichtung (10) gemäß Anspruch 13, wobei im Betrieb die zwei integrierten Quellen für eine Anode und aktiviertes Reaktivgas (20) kontinuierlich arbeiten.

15. Magnetron-Sputtervorrichtung (10) gemäß Anspruch 13, wobei im Betrieb die zwei integrierten Quellen für eine Anode und aktiviertes Reaktivgas (20) abwechselnd bei einer Frequenz von 1 Hz oder mehr arbeiten.

16. Ein Verfahren zur Verwendung der integrierten Quelle für eine Anode und aktiviertes Reaktivgas (20) gemäß Anspruch 1 zur Bereitstellung eines aktivierten Reaktivgases in eine Beschichtungskammer einer Magnetron-Sputtervorrichtung (10), wobei das Verfahren Folgendes beinhaltet:
elektrisches Koppeln der leitenden Innenfläche des Gefäßes mit einem positiven Ausgang einer Energieversorgung, sodass die leitende Innenfläche im Betrieb als Anode zur Bereitstellung einer Spannungsdifferenz für eine Kathode und als primärer Rückweg für Elektronen dient;
Bereitstellen eines Sputtergases von der Quelle des Sputtergases durch einen der einen oder mehreren Gaseinlassstutzen (29) in das Gefäß und Bereitstellen des Sputtergases durch die einzelne Öffnung (21) des Gefäßes in die Beschichtungskammer (2); und
Bereitstellen eines Reaktivgases von der Reaktivgasquelle durch einen der einen oder mehreren Gaseinlassstutzen (29) in dem Gefäß, Aktivieren des Reaktivgases innerhalb des Gefäßes und Bereitstellen des aktivierten Reaktivgases durch die einzelne Öffnung (21) des Gefäßes in die Beschichtungskammer (2).

## Revendications

1. Une source d'anode et de gaz réactif activé intégrée (20) pour une utilisation dans un dispositif de pulvérisation magnétron (10), la source d'anode et de gaz réactif intégrée (20) comprenant :
un récipient incluant :
une surface intérieure conductrice (22), conçue pour être électriquement couplée, en fonctionnement, à une sortie positive d'une alimentation en énergie, de telle sorte qu'elle serve, en fonctionnement, d'anode fournissant une différence de tension à une cathode (12) et de chemin de retour primaire pour des électrons ;
une ouverture unique (21) agencée pour communiquer, en fonctionnement, avec une chambre de revêtement (2) du dispositif de pulvérisation magnétron (10) ;
une surface extérieure isolée (26) agencée pour isoler électriquement, en fonctionnement, le récipient de parois de chambre (32) de la chambre de revêtement (2) ; et
un ou plusieurs orifices d'admission de gaz (29) ;
une source de gaz de pulvérisation et une source de gaz réactif ;
où un orifice parmi ces un ou plusieurs orifices d'admission de gaz (29) est agencé, en fonctionnement, pour fournir un gaz de pulvérisation de la source de gaz de pulvérisation dans le récipient, et la source d'anode et de gaz réactif activé intégrée est agencée de telle sorte que, en fonctionnement, le gaz de pulvérisation soit fourni à travers l'ouverture unique (21) du récipient dans la chambre de revêtement (2) ; et
où un orifice parmi ces un ou plusieurs orifices d'admission de gaz (29) est agencé, en fonctionnement, pour fournir un gaz réactif de la source de gaz réactif dans le récipient,
et la source d'anode et de gaz réactif activé intégrée est agencée, en fonctionnement,
pour activer le gaz réactif à l'intérieur du récipient et est agencée de telle sorte que, en fonctionnement, le gaz réactif activé soit fourni à travers l'ouverture unique (21) du récipient dans la chambre de revêtement (2).

2. La source d'anode et de gaz réactif activé intégrée (20) définie dans la revendication 1, où une circonférence de l'ouverture unique (21) du récipient est plus petite qu'une circonférence du récipient pour protéger, en fonctionnement, la surface intérieure conductrice (22) de la majeure partie du matériau pulvérisé.

3. La source d'anode et de gaz réactif activé intégrée (20) définie dans la revendication 2, où l'ouverture unique (21) du récipient est dimensionnée de telle sorte que, en fonctionnement, un écoulement de gaz de pulvérisation et de gaz réactif puisse être sélectionné pour élever la pression localement à l'intérieur du récipient au-dessus de la pression dans la chambre de revêtement (2).

4. La source d'anode et de gaz réactif activé intégrée (20) définie dans la revendication 3, où l'alimentation en énergie est agencée pour fournir, en fonctionnement, une tension de 15 à 80 V à la surface intérieure conductrice (22).

5. La source d'anode et de gaz réactif activé intégrée (20) définie dans la revendication 4, où ces un ou plusieurs orifices d'admission de gaz (29) consistent en un orifice d'admission de gaz unique (29), et où l'orifice d'admission de gaz unique (29) est agencé pour fournir, en fonctionnement, le gaz de pulvérisation et le gaz réactif dans le récipient.

6. La source d'anode et de gaz réactif activé intégrée (20) définie dans la revendication 4, où ces un ou plusieurs orifices d'admission de gaz (29) consistent en orifices d'admission de gaz distincts, et où les orifices d'admission de gaz distincts sont agencés pour fournir, en fonctionnement, le gaz de pulvérisation et le gaz réactif dans le récipient.

7. Un dispositif de pulvérisation magnétron (10) pour revêtir des objets, le dispositif de pulvérisation magnétron (10) comprenant la source d'anode et de gaz réactif activé intégrée (20) définie dans la revendication 4, et comprenant en outre :
une chambre de revêtement (2) conçue pour être évacuée en fonctionnement ;
une cathode (12) incluant une cible (14) comprenant un matériau pour former un revêtement ; et
une ou plusieurs zones de revêtement (17) agencées pour supporter des objets à revêtir dans la chambre de revêtement (2).

8. Le dispositif de pulvérisation magnétron (10) défini dans la revendication 7, où une distance d'un plan de surface (46) des objets à revêtir à un plan contenant l'ouverture unique (21) du récipient est supérieure ou égale à une distance du plan de surface (46) des objets à revêtir à un plan de surface (44) de la cible (14).

9. Le dispositif de pulvérisation magnétron (10) défini dans la revendication 8, comprenant en outre une deuxième source d'anode et de gaz réactif activé intégrée (20) telle que définie dans la revendication 4, où les deux sources d'anode et de gaz réactif activé intégrées (20) sont disposées à des positions substantiellement opposées adjacentes à la cathode (12).

10. Le dispositif de pulvérisation magnétron (10) défini dans la revendication 8, comprenant en outre une source de gaz réactif activé supplémentaire (36).

11. Le dispositif de pulvérisation magnétron (10) défini dans la revendication 8, où ces une ou plusieurs zones de revêtement (17) sont conçues pour tourner autour d'un axe de rotation central coïncident avec un point central de la cathode (12), et où ces une ou plusieurs zones de revêtement (17) et la source d'anode et de gaz réactif activé intégrée (20) sont disposées à une même distance radiale par rapport à l'axe de rotation central, de telle sorte que, en fonctionnement, ces une ou plusieurs zones de revêtement (17) passent directement au-dessus de l'ouverture unique (21) du récipient.

12. Le dispositif de pulvérisation magnétron (10) défini dans la revendication 8, où la cathode (12) et la source d'anode et de gaz réactif activé intégrée (20) sont disposées de façon adjacente l'une par rapport à l'autre à une même distance radiale par rapport à un axe de rotation central, et où ces une ou plusieurs zones de revêtement (17) sont conçues pour tourner autour de l'axe de rotation central à la même distance radiale par rapport à l'axe de rotation central que la cathode (12) et la source d'anode et de gaz réactif activé intégrée (20), de telle sorte que, en fonctionnement, ces une ou plusieurs zones de revêtement (17) passent directement par-dessus la cathode (12) et la source d'anode et de gaz réactif activé intégrée (20).

13. Le dispositif de pulvérisation magnétron (10) défini dans la revendication 9, où la cathode (12) est disposée à une distance radiale par rapport à un axe de rotation central, et les deux sources d'anode et de gaz réactif activé intégrées (20) sont disposées à la même distance radiale par rapport à l'axe de rotation central que la cathode d'un côté et de l'autre de la cathode (12), où ces une ou plusieurs zones de revêtement (17) sont conçues pour tourner autour de l'axe de rotation central à la même distance radiale par rapport à l'axe de rotation central que la cathode (12) et les deux sources d'anode et de gaz réactif activé intégrées (20), de telle sorte que, en fonctionnement, ces une ou plusieurs zones de revêtement (17) passent directement par-dessus la cathode (12) et les deux sources d'anode et de gaz réactif activé intégrées (20).

14. Le dispositif de pulvérisation magnétron (10) défini dans la revendication 13, où, en fonctionnement, les deux sources d'anode et de gaz réactif activé intégrées (20) fonctionnent en continu.

15. Le dispositif de pulvérisation magnétron (10) défini dans la revendication 13, où, en fonctionnement, les deux sources d'anode et de gaz réactif activé intégrées (20) fonctionnent en alternance à une fréquence de 1 Hz ou plus.

16. Un procédé d'utilisation de la source d'anode et de gaz réactif activé intégrée (20) définie dans la revendication 1 pour fournir un gaz réactif activé dans une chambre de revêtement d'un dispositif de pulvérisation magnétron (10), le procédé comprenant :
le fait de coupler électriquement la surface intérieure conductrice du récipient à une sortie positive d'une alimentation en énergie, de telle sorte que la surface intérieure conductrice serve, en fonctionnement, d'anode fournissant une différence de tension à une cathode et de chemin de retour primaire pour des électrons ;
le fait de fournir un gaz de pulvérisation d'une source de gaz de pulvérisation à travers un orifice parmi ces un ou plusieurs orifices d'admission de gaz (29) dans le récipient, et le fait de fournir le gaz de pulvérisation à travers l'ouverture unique (21) du récipient dans la chambre de revêtement (2) ; et
le fait de fournir un gaz réactif de la source de gaz réactif à travers un orifice parmi ces un ou plusieurs orifices d'admission de gaz (29) dans le récipient, le fait d'activer le gaz réactif à l'intérieur du récipient et le fait de fournir le gaz réactif activé à travers l'ouverture unique (21) du récipient dans la chambre de revêtement (2).
